# EUROPÄISCHE PATENTANMELDUNG

(11) **EP 0 763 894 A2**
(43) Veröffentlichungstag der Anmeldung: **19.03.1997**
(21) Anmeldenummer: 96111673.8
(22) Anmeldetag: 18.07.1996
(51) Int. Cl.: H03K 17/082

(54) **Durch Feldeffekt steuerbares Halbleiterbauelement mit mehreren Temperatursensoren**

(30) Priorität: 18.09.1995 DE 19534604
(71) Anmelder: SIEMENS AKTIENGESELLSCHAFT, 80333 München (DE)
(72) Erfinder: Sander, Rainald, Dipl.-Phys., 81379 München (DE); Graf, Alfons, Dr.-Ing., 86916 Kaufering (DE)

(57) **Zusammenfassung**

In den Halbleiterkörper (1) eines Leistungs-MOSFET oder IGBT sind mindestens zwei Temperatursensoren (4, 5) integriert, die an verschiedenen Orten innerhalb des Zellenfeldes (3) angeordnet sind. Damit wird der Temperaturgradient zwischen einem stark erhitzten, lokalen Bereich des Halbleiterkörpers und einem der Temperatursensoren verringert und die Ansprechzeit im Überlastfall verkürzt sich.

## Beschreibung

Die Erfindung bezieht sich auf ein durch Feldeffekt steuerbares Leistungs-Halbleiterbauelement mit einem Halbleiterkörper, der eine Vielzahl von einander parallel geschalteten Transistorzellen hat, die in mindestens einem Zellenfeld angeordnet sind.

Zum Schutz eines solchen Halbleiterbauelementes, das z.B. ein Leistungs-MOSFET oder ein IGBT sein kann, gegen Überlastung wurde z.B. in der EP 0 224 274 vorgeschlagen, einen Temperatursensor im Zentrum des Halbleiterkörpers anzuordnen. Der Temperatursensor sitzt in einer Aussparung eines Feldes von Transistorzellen, die einander parallel geschaltet sind.

Wird die Last ganz oder teilweise kurzgeschlossen, so erhitzt sich der Halbleiterkörper aufgrund von Inhomogenitäten an bevorzugten, lokalen Stellen. Nach einer durch den transienten thermischen Widerstand zwischen diesen Stellen und dem Temperatursensor bestimmten Zeit erfaßt der Sensor die Übertemperatur und schaltet das Leistungs-Halbleiterbauelement ab.

Bei Leistungs-Halbleiterbauelementen hoher Leistung muß die Fläche des Halbleiterkörpers großer werden. Mit größer werdender Fläche des Halbleiterkörpers wächst aber die Wahrscheinlichkeit, daß das Leistungs-Halbleiterbauelement zerstört wird, bevor der Temperatursensor anspricht.

Der Erfindung liegt die Aufgabe zugrunde, ein Leistungs-Halbleiterbauelement der genannten Art so weiterzubilden, daß die Wahrscheinlichkeit der Zerstörung durch Überlast drastisch verringert wird.

Dies wird erreicht durch mindestens zwei in den Halbleiterkörper integrierte, an voneinander verschiedenen Orten auf dem Halbleiterkörper angeordnete Temperatursensoren.

Weiterbildungen der Erfindung sind Gegenstand der Unteransprüche.

Die Erfindung wird anhand zweier Ausführungsbeispiele in Verbindung mit den Figuren 1 bis 5 naher erläutert. Es zeigen:
- Figur 1: die Aufsicht auf ein erstes Ausführungsbeispiel,
- Figur 2: die Aufsicht auf ein zweites Ausführungsbeispiel,
- Figur 3 bis 5: verschiedene Schaltungsanordnungen, in denen die Temperatursensoren auf unterschiedliche Weise mit die Leistungs-Halbleiterbauelemente steuernden Ansteuerschaltungen verbunden sind.

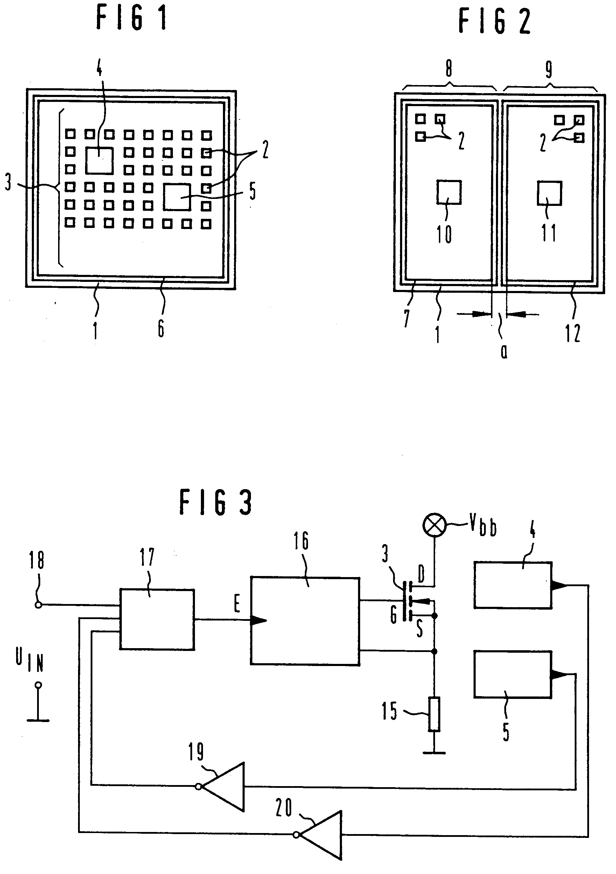

Das Leistungs-Halbleiterbauelement nach Figur 1 hat einen Halbleiterkörper 1 mit einer Vielzahl von durch Feldeffekt gesteuerten Transistorzellen 2. Diese Transistorzellen sind auf bekannte Art und Weise in den Halbleiterkörper integriert und einander parallel geschaltet. Üblicherweise werden sie durch eine allen Transistorzellen gemeinsame Gateelektrode gesteuert, die hier jedoch der besseren Übersicht wegen weggelassen wurde. Die Transistorzellen 2 sind geometrisch in Form eines Zellenfeldes 3 angeordnet. Die Anzahl der Zellen kann z.B. einige 10000 betragen. Der besseren Übersichtlichkeit halber sind hier nur einige Zellen 2 dargestellt, die außerdem im Verhältnis zur Fläche des Halbleiterkörpers stark vergrößert sind.

Innerhalb des Zellenfeldes 3 sind an verschiedenen Orten des Halbleiterkörpers zwei Temperatursensoren 4, 5 in den Halbleiterkörper integriert. Es können auch mehr als zwei Temperatursensoren in den Halbleiterkörper integriert sein.

Diese Temperatursensoren können z.B. Bipolartransistoren oder Dioden sein.

Bei Überlast z.B. durch teilweisen oder vollständigen Kurzschluß der Last fließt ein gegenüber dem Nennstrom erhöhter Laststrom. Dieser konzentriert sich aufgrund der erwähnten unvermeidbaren Inhomogenitäten auf eine oder mehrere Transistorzellen 2 des Zellenfeldes 3. Diese Zellen erhitzen sich damit stark und erwärmen den Halbleiterkörper. Gegenüber einem Halbleiterkörper mit nur einem einzigen Temperatursensor ist wegen des geringeren Abstandes zwischen einer überlasteten Zelle und einem der Sensoren der Temperaturgradient kleiner. Der den genannten Zellen benachbarte Temperatursensor spricht daher schneller an. Sein Signal kann einer Ansteuerschaltung zugeführt werden, die das Leistungs-Halbleiterbauelement entweder ganz abschaltet oder den Strom durch Reduktion der Steuerspannung soweit absenkt, bis das Leistungs-Halbleiterbauelement durch ein externes Signal abgeschaltet wird. Eine Zerstörung des Leistungs-Halbleiterbauelements kann damit verhindert werden.

In Figur 3 ist ein Ausführungsbeispiel für eine Ansteuerschaltung für das Leistungs-Halbleiterbauelement nach Figur 1 gezeigt. Das Leistungs-Halbleiterbauelement enthält das Zellenfeld 3 und ist auch durch die Ziffer 3 symbolisiert. Ihm ist sourceseitig eine Last 15 in Reihe geschaltet. Die Reihenschaltung liegt an einer Spannung V_{bb}. Die Steuerspannung wird von einer Ansteuerschaltung 16 geliefert und zwischen den Gateanschluß G und den Sourceanschluß S angelegt. Die Ansteuerschaltung 16 wird an einem Eingang E (Enable) durch eine Logikschaltung 17 (UND-Schaltung) freigegeben, wenn am Steuereingang 18 eine Steuerspannung Uᵢₙ anliegt und die Temperatursensoren 4, 5 einen Ausgangspegel L haben. Dies ist bei normaler Betriebstemperatur der Fall. Die Temperatursensoren 4, 5 sind über Inverter 19, 20 mit zwei weiteren Eingängen der Logikschaltung 17 verbunden.

Hat einer oder haben beide Temperatursensoren 4, 5 angesprochen, so wird die Ansteuerschaltung 16 über die Logikschaltung 17 am Eingang E gesperrt und das Leistungs-Halbeiterbauelement wird abgeschaltet. Sein Laststrom kann aber auch lediglich reduziert werden, bis das Leistungs-Halbleiterbauelement extern durch ein Signal am Steuereingang 18 abgeschaltet wird.

Im Ausführungsbeispiel nach Figur 2 ist der Halbleiterkörper wieder mit 1 bezeichnet. Die Transistorzellen sind hier in Form von zwei Zellenfeldern 8, 9 auf dem Halbleiterkörper 1 angeordnet. Die Zellenfelder haben einen Abstand a von einander, der in der gleichen Größenordnung wie die Dicke des Halbleiterkörpers liegt. Ist die Dicke des Halbleiterkörpers z.B. 300 µm, so kann der Abstand a z.B. 100 µm betragen. Im Zellenfeld 8 ist ein Temperatursensor 10 angeordnet, im Zellenfeld 9 ein Temperatursensor 11. Die Temperatursensoren 10, 11 sind vorzugsweise dort angeordnet, wo die höchste Temperatur zu erwarten ist. Dies ist die geometrische Mitte, d.h. der Kreuzungspunkt der Diagonalen der Zellenfelder 8, 9. Es können auch hier mehrere Temperatursensoren pro Zellenfeld vorhanden sein.

Durch Aufteilung einer gleichen Anzahl von Transistorzellen in zwei oder mehr Zellenfelder wird der Abstand von einer oder mehrerer der überlasteten Zellen zum Temperatursensur relativ klein. Die Fläche zwischen den Zellenfeldern wirkt hier als Wärmesenke. Dadurch können die Zellenfelder als thermisch-dynamisch voneinander getrennte Leistungs-Halbleiterbauelemente betrachtet werden mit einem gegenüber dem Halbleiterbauelement nach Figur 1 größeren Verhältnis von Randlänge zu Fläche. Im statischen Normalbetrieb ergeben sich durch die Teilung der Zellenfelder keine Unterschiede in der Temperatur. Im dynamischen Überlastfall sind jedoch die sich überhitzenden Zellen auf einer relativ kleinen Fläche rund um die geometrische Mitte der geteilten Zellenfelder verteilt.

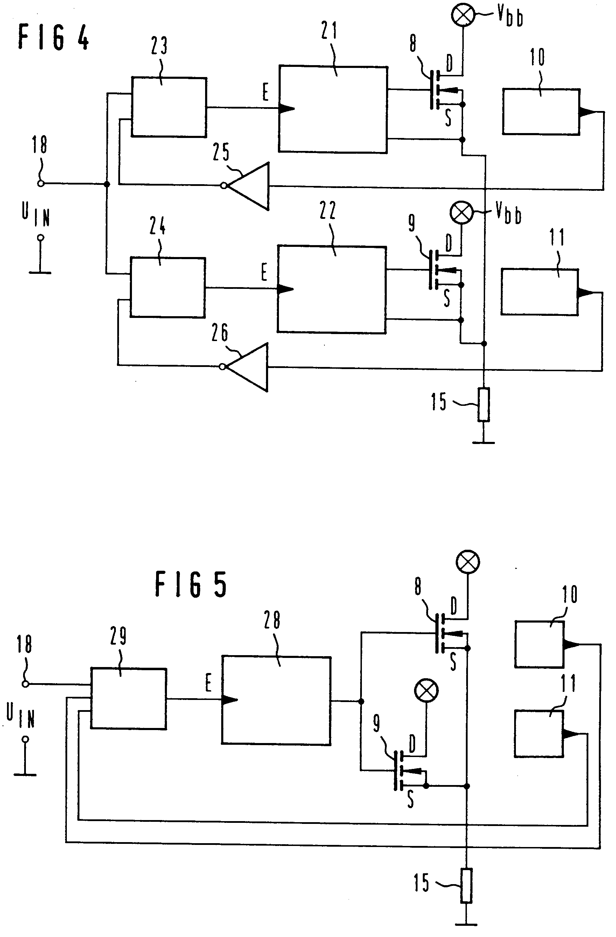

Die Zellenfelder können bei Überlast getrennt oder gemeinsam abgeschaltet werden. Zum getrennten Abschalten der Zellenfelder ist beispielsweise die Schaltung nach Figur 4 geeignet. Hier sind zwei Leistungs-Halbleiterbauelemente parallel geschaltet. Sie sind durch die Zellenfelder 8 und 9 gebildet und auch mit den Bezugszeichen 8, 9 versehen. Der zum Zellenfeld 8 gehörende Temperatursensor ist über einen Inverter 25 mit einem Eingang einer Logikschaltung 23 (UND) verbunden. Ein zweiter Eingang dieser Logikschaltung steht mit dem Steuereingang 18 in Verbindung. Der Ausgang der Logikschaltung 23 ist mit dem Eingang E (Enable) einer Ansteuerschaltung 21 verbunden. Deren Funktion entspricht der der Ansteuerschaltung 16 nach Figur 3.

Der zum Zellenfeld 9 gehörende Temperatursensor 11 ist ausgangsseitig Ober einen Inverter 24 mit einem Eingang einer Logikschaltung 24 (UND) verbunden, deren zweiter Eingang mit dem Steuereingang 18 in Verbindung steht. Der Ausgang von 24 ist mit dem Eingang E einer Ansteuerschaltung 22 verbunden, an deren Ausgang die Steuerspannung für das Zellenfeld 9 liegt. Die Zellenfelder 8, 9 sind einander parallel geschaltet und sourceseitig mit der Last 15 verbunden.

Signalisiert einer der Temperatursensoren Übertemperatur, so liegt an seinem Ausgang das Signal H an. Dieses wird im Inverter 25 invertiert. An einem Eingang der Logikschaltung 23 liegt dann das Signal L und das Zellenfeld 8 wird dann über die Ansteuerschaltung 21 gesperrt oder es wird als Alternative der Laststrom reduziert.

Auf gleiche Weise wird das Zellenfeld 9 über den Temperatursensor 11 den Inverter 26, die Logikschaltung 24 und die Ansteuerschaltung 22 gesteuert. Tritt eine Überlastung nur eines der beiden Zellenfelder auf, so wird dieses gesperrt und das andere Zellenfeld arbeitet mit Nennstrom weiter.

Die Schaltungsanordnung nach Figur 5 unterscheidet sich von der nach Figur 4 dadurch, daß die Ausgänge beider Temperatursensoren und der Steuereingang 18 auf ein UND-Gatter 29 mit drei Eingängen gelegt sind. Signalisiert einer der Temperatursensoren 10, 11 Übertemperatur, so werden beide Zellenfelder 8, 9 und damit das gesamte Leistungs-Halbleiterbauelement gesperrt.

Das Ausführungsbeispiel nach Figur 2 kann auch so modifiziert werden, daß der Halbleiterkörper mehr als zwei Zellenfelder mit je einem Temperatursensor enthält. Um die elektrischen Eigenschaften wie Durchbruchspannung und Sperrstrom nicht zu verschlechtern, sind die Zellenfelder vorzugsweise von Randstrukturen umgeben, die in Figur 2 mit 7 und 12 bezeichnet sind und in Figur 1 mit 6. Solche Randstrukturen sind bekannt, sie bestehen üblicherweise aus mindestens einer Feldplatte und einer Kanal-Stopper-Elektrode. Im übrigen wird dazu z.B. auf die Europäischen Patente No. 0 037 115 und 0 077 481 verwiesen.

Die Ansteuerschaltungen können mit dem Leistungs-Halbleiterbauelement in einen einzigen Halbleiterkörper integriert werden.

## Patentansprüche

1. Durch Feldeffekt steuerbares Leistungs-Halbleiterbauelement mit einem Kalbleiterkörper (1), der eine Vielzahl von einander parallel geschalteten Transistorzellen (2), die in mindestens einem Zellenfeld (3, 8, 9) angeordnet sind, mit mindestens zwei in den Halbleiterkörper integrierten, an yoneinander verschiedenen Orten auf dem Halbleiterkörper angeordneten Temperatursensoren (4, 5).

2. Leistungs-Halbleiterbauelement nach Anspruch 1,
**dadurch gekennzeichnet,** daß die Transistorzellen (2) in mindestens zwei voneinander beabstandeten Zellenfeldern (8, 9) auf dem Halbleiterkörper (1) angeordnet sind und daß jedes Zellenfeld einen Temperatursensor (10, 11) enthält.

3. Leistungs-Halbleiterbauelement nach Anspruch 2,
**dadurch gekennzeichnet,** daß die Temperatursensoren (10, 11) an derjenigen Stelle der Zellenfelder (8, 9) angeordnet sind, wo die höchste Temperatur zu erwarten ist.

4. Leistungs-Halbleiterbauelement nach Anspruch 2 oder 3,
**dadurch gekennzeichnet,** daß die Zellenfelder einen Abstand (a) voneinander haben, der in der gleichen Größenordnung wie die Dicke des Halbleiterkörpers liegt.

5. Leistungs-Halbleiterbauelement nach Anspruch 4,
**dadurch gekennzeichnet,** daß die Zellenfelder von je einer Randstruktur (7, 12) umgeben sind.

6. Leistungs-Halbleiterbauelement nach Anspruch 1,
**gekennzeichnet durch** eine Ansteuerschaltung (16), die die Steuerspannung für das Halbleiterbauelement liefert und die die Steuerspannung herabsetzt, so lange mindestens einer der Temperatursensoren (4, 5) ein Signal abgibt.

7. Leistungs-Halbleiterbauelement nach einem der Ansprüche 2 bis 5,
**gekennzeichnet durch** eine allen Zellenfeldern (8, 9) gemeinsame Ansteuerschaltung (28), die die Steuerspannung für alle Zellenfelder liefert und die die Steuerspannung für alle Zellenfelder herabsetzt, so lange mindestens einer der Temperatursensoren (10, 11) ein Signal abgibt.

8. Leistungs-Halbleiterbauelement nach einem der Ansprüche 2 bis 5,
**gekennzeichnet durch** eine Ansteuerschaltung (21, 22) für jedes Zellenfeld (10, 11), die die Steuerspannung liefert und die die Steuerspannung für das zugeordnete Zellenfeld (8, 9) herabsetzt, so lange der Temperatursensor des Zellenfeldes ein Signal abgibt.
